(19)

Europäisches
Patentamt
European
Patent Office
Office européen
des brevets

(11) EP 2 397 864 A1

(12) EUROPEAN PATENT APPLICATION

(43) Date of publication:
21.12.2011 Bulletin 2011/51

(51) Int Cl.:
$G01R\ 35/04^{(2006.01)}$    $G01R\ 21/133^{(2006.01)}$

(21) Application number: 10166497.7

(22) Date of filing: 18.06.2010

(84) Designated Contracting States:
AL AT BE BG CH CY CZ DE DK EE ES FI FR GB
GR HR HU IE IS IT LI LT LU LV MC MK MT NL NO
PL PT RO SE SI SK SM TR
Designated Extension States:
BA ME RS

(71) Applicant: NXP B.V.
5656 AG Eindhoven (NL)

(72) Inventor: Vlemmings, Marc
5656 AE, Eindhoven (NL)

(74) Representative: Krott, Michel
NXP B.V.
IP & Licensing Department
High Tech Campus 60
5656 AG Eindhoven (NL)

(54) **Electricity meter and method for determining a quantity**

(57)    It is provided a method for determining a quantity, the method comprising: acquiring an electric current value ($I_i$) and an electric voltage value ($V_i$) associated with the electric current value; further acquiring at least one further electric current value and at least one further electric voltage value associated with the at least one further electric current value; deriving the quantity (P, Q) based on the current value, on the associated voltage value, on the at least one further current value, and on the associated at least one further voltage value; correcting the derived quantity based on a predetermined phase error (L1<p) between the current value and the associated voltage value and between the at least one further current value and the at least one further associated voltage value. It is further provided an electricity meter.

Fig. 2

## Description

FIELD OF THE INVENTION

The present invention relates to an electricity meter and to a method for determining a quantity which are in particular suitable to measure electric power related quantities, such as active power, reactive power, apparent power and/or power factor. In particular, the present invention relates to an electricity meter and to a method for determining a quantity, wherein the quantity is derived based on plural electric voltage values and plural electric current values associated with the plural electric voltage values.

BACKGROUND OF THE INVENTION

In conventional electricity meters and methods for measuring (temporarily alternating) electric quantities, an unknown phase error between current and voltage may be introduced during the measurement, e.g. by current transformers. Further, one or more analogue-to-digital converters may be present and differences in analogue-to-digital converter (ADC) sample timing for acquiring voltage values and current values may lead to a static unknown phase error between the measured voltage and current values.

There may be electric quantities derived from the current and the voltage acquired by the electricity meter that may be sensitive to a phase difference φ between the current and the voltage. These quantities may include for example active power, reactive power, and power factor. Thus, when an unknown phase error between voltage and current is introduced by the electricity meter or by the method for determining an electrical quantity during the measurement, the measurement of an electrical quantity being sensitive to the phase shift between voltage and current, may be inaccurate.

In a conventional electricity meter or in a method for phase compensation in electronic energy meters, such as disclosed in WO 03/021279 A1 and illustrated in Fig. 5, a digital filter is provided for delaying one or both of the digital voltage and the digital current values to compensate for a phase shift error in the sensing circuit. In a computation circuit one or more parameters of the digital filter are computed to compensate for the phase error between voltage and current. This conventional electronic meter may be calibrated by applying to the meter a test wave form having known phase shift, measuring the phase shift using the electronic meter, determining a phase shift error based on the difference between the known phase shift and the measured phase shift and determining digital filter coefficients to produce a digital filter delay that corresponds to the phase shift error. For actually measuring an electronic or electric quantity depending on voltage and current, voltage and current values are sampled and each sampled value is filtered using the digital filter delay in the prior art. In particular, if the sampling rate is relatively high such as one or more kilohertz (kHz), filtering each of the sampled values by the digital filter delay may produce a computational burden or overhead, thus requiring high processing power, which may not be available. Further, these computational needs may require a digital signal processor or a hardware accelerator increasing the complexity and costs of the electric meter.

OBJECT AND SUMMARY OF THE INVENTION

There may be a need for an electricity meter and for a method for determining an electric quantity, which is in particular suitable for determining an electric quantity, which is related to voltage and current, and in particular sensitive to a phase shift between voltage and current. Further, there may be a need for an electricity meter and a method for determining a quantity, which requires less computational efforts or less expensive computational equipment for accurately determining an electric quantity being sensitive to voltage, current and a phase shift between voltage and current. In particular, there may be a need for an electricity meter and for a method for determining an electric quantity, which is suitable for measuring an electric quantity being sensitive to alternating current, alternating voltage and a phase shift between the alternating current and the alternating voltage. The electric quantity to be determined may be for example active power, reactive power and/or a power factor.

According to an embodiment, a method for determining a quantity is provided, wherein the method comprises acquiring an electric voltage value and an electric current value associated with the electric voltage value; further acquiring at least one further electric voltage value and at least one further electric current value associated with the at least one further electric voltage value; deriving the quantity based on the voltage value, on the associated current value, on the at least one further voltage value, and on the associated at least one further current value; correcting the derived quantity based on a predetermined phase error between the voltage value and the associated current value and between the at least one further voltage value and the at least one further associated current value.

The acquiring the electric current value may comprise supplying an electric current to a terminal and running the electric current through a primary coil of a current transformer, running a current through a secondary coil of the current transformer and running the current through a shunt resistor, and further sensing a voltage drop by running the current through the shunt resistor. In particular, the acquiring the electric current value may introduce an (or at least a part of an) unknown phase error between voltage and current. Further, the acquiring the electric current value may comprise sampling the voltage drop by an analogue-to-digital converter (ADC) at a sampling rate, which may be adapted to the current application.

The acquiring the electric current value may comprise supplying an electric current to a terminal and further sensing a voltage drop by running the current directly through a series resistor between a power source and a load.

The acquiring the electric voltage value associated with the electric current voltage value may comprise providing a resistor voltage divider and sensing a voltage drop occurring across a particular resistor of the resistor voltage divider. Further, the acquiring the electric voltage value may comprise digitizing or sampling the voltage drop using an ADC having a sampling rate adapted for the current application. In particular, the sampling rate used for sampling or digitizing the current value, may be substantially be the same as the sampling rate for digitizing or sampling the electric voltage value.

The acquiring the electric voltage value associated with the electric current voltage value may comprise providing the power source voltage to the primary side of a voltage transformer and sensing the voltage on the secondary side of a voltage transformer.

The electric voltage value may be associated with the electric current value in that the electric current value and the electric voltage value are measured substantially simultaneously or measured at different time points having a fixed time interval in between. The electric current value and the electric voltage value associated with the electric current value may be also referred to as current voltage pair. In particular, the electric current may be an alternating electric current and the electric voltage may be an alternating electric voltage.

Additionally, to a first pair of an electric current value and an associated electric voltage value, at least one further pair of a further electric current value and a further associated electric voltage value are acquired, which may comprise similar steps or processes as the acquiring the first pair of electric current value and associated electric voltage value. In particular, a plurality of pairs of current values and associated voltage values may be acquired such as at a predetermined repetitions rate, which may be at least five times, ten times, or fifty times higher than a frequency of the alternating current or the alternating voltage.

The quantity to be determined may in particular comprise an electric quantity, which is derivable by taking into account current and voltage acquired at different time points. In particular, the electric quantity may depend on a plurality of pairs of a current value and an associated voltage value, which pairs may have been acquired at subsequent time points, such as by sampling and/or digitizing.

In particular, the electric quantity may comprise or be an active power, a reactive power and/or a power factor. Thereby, the active power may be represented as a scalar product of voltage and current or may be represented using sampled values of the current and the voltage as a sum of products of pairs of voltage and current. The reactive power may be represented as a scalar product of the current and the phase shifted voltage, wherein the voltage may be shifted in particular by 90°. In particular, when using sampled and/or digitized values, the reactive power may be represented as a sum of products of pairs of the current and the phase shifted voltage. Alternatively the current may be phase shifted. The power factor may be derived as a fraction of the active power and the apparent power, wherein the apparent power may be represented as the root-mean-square (RMS) value of the current multiplied with the root-mean-square (RMS) value of the voltage. In particular, the power factor may be represented as $\cos(\varphi)$, wherein $\varphi$ represents the actual phase shift (already compensated for the unknown phase error) between current and voltage. According to other embodiments, the electric quantity may comprise other quantities related to current and voltage.

In particular, the electric quantity may be based on at least two pairs of current values and associated voltage values. In particular, the electric quantity may be represented by an equation comprising at least two pairs of current values and associated voltage values. According to an embodiment, the electric quantity may be based on at least 10 pairs, 100 pairs, 1.000 pairs, or even more pairs of electric current values and electric voltage values, which may have in particular been acquired by sensing the current and voltage and sampling the sensed current and voltage and/or digitizing the sampled current and voltage to obtain plural pairs of electric current values and electric voltage values. After deriving the electric quantity, the derived quantity may be corrected based on the predetermined phase error. Thus, not the acquired pairs of electric current values and electric voltage values are corrected individually, but only the derived quantity is corrected, thus simplifying the correction method and requiring less computational power and thus less time and costs. Thereby, in particular, power calculations may be done with the raw voltage and raw current samples and compensation or correction may be done after the power calculations are done. Thereby, the correction or compensation may involve the phase compensation or correction of the phase error. Thereby, the compensation or correction may have to be done only once per power calculation interval, which may be much larger than a typical sampling interval.

The phase error may be due to different processes during the acquiring the electric current value and/or the acquiring the electric voltage value and/or the further acquiring the at least one further electric current value and/or the further acquiring the at least one further electric voltage value associated with the at least one further electric current value. In particular, the phase error may be due to an unknown phase shift introduced during transformation of an original current using a current transformer having a primary coil and a secondary coil, which is connected to a shunt resistor. The phase error may be determined according to different methods as described below. It may be assumed that the phase error is independent of a magnitude of the electric current and the electric voltage and it may be assumed that the phase error is constant or does not change over time. Correcting the derived quantity instead of correcting the individual pairs of electric current value and electric voltage value, may simplify and accelerate the method and may require less computational equipment or computational power. Thereby, the method according to an embodiment may compensate for the phase error in the active power (P) and the reactive power (Q) domain. According to an embodiment, the sampled values of current end voltage (such as integer ADC samples) for the initial power calculation may remain unaltered and compensation may be done only for every power measurement (e.g. one time per second).

According to an embodiment the deriving the quantity, in particular at a rate between 0.1 Hz and 60 Hz, comprises multiplying at least one of the current value and the at least one further current value with at least one of the voltage value and the at least one further voltage value. Thus, the quantity may depend on at least one product of current and voltage, in particular on a product of at least one pair of current value and voltage value. Thereby, easy calculation of the quantity may be achieved.

According to an embodiment, the multiplying comprises multiplying the current value with the voltage value and multiplying the at least one further current value with the at least one further voltage value. In particular, the multiplying may comprise multiplying at least one pair of current and voltage.

According to an embodiment, the deriving the quantity further comprises forming a sum of at least two products obtained by the multiplying. In particular, the derived quantity may be represented as a sum of products of pairs of voltage values and current values. In particular, for forming the products, at least one of the current and the voltage may be phase-shifted. Thereby, in particular, an active power (P) may be obtained by forming a sum of products of pairs of current value and voltage value, wherein no phase shift is performed. In particular, a reactive power (Q) may be presented as a sum of products of pairs of current values and phase-shifted voltage values, wherein the phase shift may in particular be 90°.

According to an embodiment, the correcting the derived quantity comprises determining an apparent phase shift between the current value and the associated voltage value and between the at least one further current value and the at least one further associated voltage value. The apparent phase shift $\varphi'$ may not represent the actual phase shift $\varphi$ between current and voltage, but may represent the actual phase shift deteriorated by the predetermined phase error $\Delta\varphi$. Not correcting the apparent phase shift by the predetermined phase error may result in an inaccurate measurement of the electric quantity. The determining the apparent phase shift may involve forming a fraction of the reactive power and the active power; a fraction of the active power and an absolute value of the apparent power; or a fraction of the reactive power and an absolute value of the apparent power. Further, at least one of the obtained fractions may be used as an argument in a trigonometric function, such as tan, cos, or sin. In particular, the apparent phase shift may be referred to as $\varphi'$, while the actual phase shift may be referred to as $\varphi$.

According to an embodiment, the correcting the derived quantity further comprises correcting the apparent phase shift using the predetermined phase error. In particular, the apparent phase shift may be corrected by subtracting the predetermined phase error. Thereby, in a simple way the power factor $\cos(\varphi)$ may be determined.

According to an embodiment, the correcting the quantity further comprises evaluating a trigonometric function depending on the corrected apparent phase shift (being the actual phase shift). In particular, the corrected active power may be represented by the apparent power multiplied with the cosine of the actual phase shift, wherein the actual phase shift is obtained by subtracting the predetermined phase error from the apparent phase shift between the current value and the associated voltage value.

In particular, the reactive power may be represented as a product of the apparent power and sine of the actual phase shift between the current value and the associated voltage value, wherein the actual phase shift between the current value and the associated voltage value may be obtained by subtracting the predetermined phase error from the apparent phase shift between the current value and the associated voltage value. Thereby, the derived quantity may be corrected in an easy way requiring only reduced computational efforts.

According to an embodiment the acquiring and/or the further acquiring comprises sampling, in particular at a rate between 100 Hz and 100 kHz, and/or digitizing the electric current value and/or the associated electric voltage value and/or the at least one further electric current value and/or the at least one further associated electric voltage value. Thereby, deriving the quantity may even further be simplified. The digitizing may in particular comprise digitizing the corresponding values using an analogue-to-digital converter. In particular, the digitizing may be performed at substantially same sampling rates. The sampling rate may depend on a frequency of the alternating current and/or the alternating voltage. In particular, the current may be digitized at a same time point as the voltage is digitized to obtain a pair of current and voltage. Thereby in particular, the sampled and/or digitized electric current values and associated electric voltage values may not be corrected taking into account the predetermined phase error. Instead, only the derived quantity being computed from a plurality of pairs of electric voltage value and electric current value, may be corrected depending on the predetermined phase error.

According to an embodiment, the acquiring the electric current value and/or the further acquiring the at least one further electric current value comprises transforming a load current and/or at least one further load current using a transformer. Thereby, the load current may flow through a primary coil of the transformer and a secondary current may flow through a secondary coil (inductively coupled to the primary coil) of the transformer, which may also flow through a shunt resistor causing a voltage drop, which may be proportional to the original load current. Thereby, the phase error may be influenced.

According to an embodiment, the quantity is an active power and/or a reactive power and/or an apparent power and/or a power factor. Thereby, important quantities may be determined using the method according to an embodiment. In particular, properties of an electric power production facility may be measured using the method according to an embodiment.

According to an embodiment, the method for determining a quantity further comprises determining the predetermined phase error between the current value and associated voltage value and between the between the at least one further current value and the at least one further associated voltage value by acquiring a reference electric current value and a reference electric voltage value associated with the reference electric current value and by further acquiring at least one further reference electric current value and at least one further reference electric voltage value associated with the at least one further reference electric current value, wherein a predetermined reference phase shift is present between the reference current value and associated reference voltage value and between the at least one further reference current value and the at least one further associated reference voltage value.

In particular, the reference electric current value and the reference electric voltage value associated therewith, may be acquired by connecting a resistive load to a power supply and measuring the current running through the load and measuring the voltage dropping across the load. In particular, the resistive load may provide current and voltage, which have an actual phase shift of 0° relative to each other. In particular, the resistive load may not have any capacitive load and may not have any inductive load. Thus, no phase shift may be introduced, when the current runs through the resistive load. Thereby, the predetermined reference phase shift may be 0, when using a resistive load.

In particular, the determining the phase error may comprise determining a reference quantity based on the pair of the reference electric current value and reference electric voltage value and the pair of the further reference electric current value and the further reference electric voltage value. In particular, the reference quantity may comprise an active power, a reactive power, and/or a power factor. A deviation of the reference quantity from an expected reference quantity may depend on the phase error to be determined. In particular, the determination of the phase error, may involve forming a fraction of the reference reactive power and the reference active power; a fraction of the reference active power and the reference apparent power; and a fraction of the reference reactive power and the reference apparent power. Further, determining the phase error may further involve applying a trigonometric function to at least one of the obtained fractions. Thereby, the phase error to be used in the method for determining a quantity, may easily be determined by using a reference load, acquiring a number of pairs or reference electric current values and reference electric voltage values; deriving the reference quantity and obtaining the phase error to be determined from at least one such reference quantity.

According to an embodiment, the method for determining a quantity further comprises storing and/or accessing the predetermined phase error, such as in a computer storage. Thereby, the predetermined phase error may be used as a calibration value, when performing the method for determining a quantity.

According to an embodiment, an electricity meter for determining a quantity is provided, wherein the electricity meter comprises a current terminal for acquiring an electric current value and at least one further electric current value; a voltage terminal for acquiring an electric voltage value associated with the electric current value and at least one further electric voltage value associated with the at least one further electric current value; a processing apparatus adapted for deriving the quantity based on the current value, on the associated voltage value, on the at least one further current value, and on the associated at least one further voltage value; and for correcting the derived quantity based on a predetermined phase error between the current value and the associated voltage value and between the at least one further current value and the at least one further associated voltage value.

It should be understood that any feature disclosed with respect to the method for determining a quantity, may (individually or in any combination of other disclosed feature(s)) be applied to the electricity meter according to an embodiment. Thereby, elements, components or technical arrangements of the electricity meter are adapted by physical means to perform the functions and/or purposes claimed in the method claims.

According to an embodiment a computer readable medium is provided, in which a computer program of determining a quantity is stored, which computer program, when being executed by a processor, is adapted to carry out or control a method for determining a quantity according to an embodiment as described above.

According to an embodiment, a program element of determining a quantity is provided, which program element, when being executed by a processor, is adapted to carry out or control a method for determining a quantity according to an embodiment as described above.

BRIEF DESCRIPTION OF THE FIGURES

Fig. 1 schematically illustrates a block diagram of an electricity meter according to an embodiment.

Fig. 2 schematically illustrates a block diagram of a processor and a method for determining a quantity according to an embodiment, which may be carried out by the electricity meter illustrated in Fig. 1;

Fig. 3 schematically illustrates a graph showing a method step for determining the phase error according to an embodiment;

Fig. 4 schematically illustrates a graph resulting from a method for determining a quantity according to an embodiment; and

Fig. 5 schematically illustrates a phase compensation method according to the prior art.

DESCRIPTION OF EMBODIMENTS

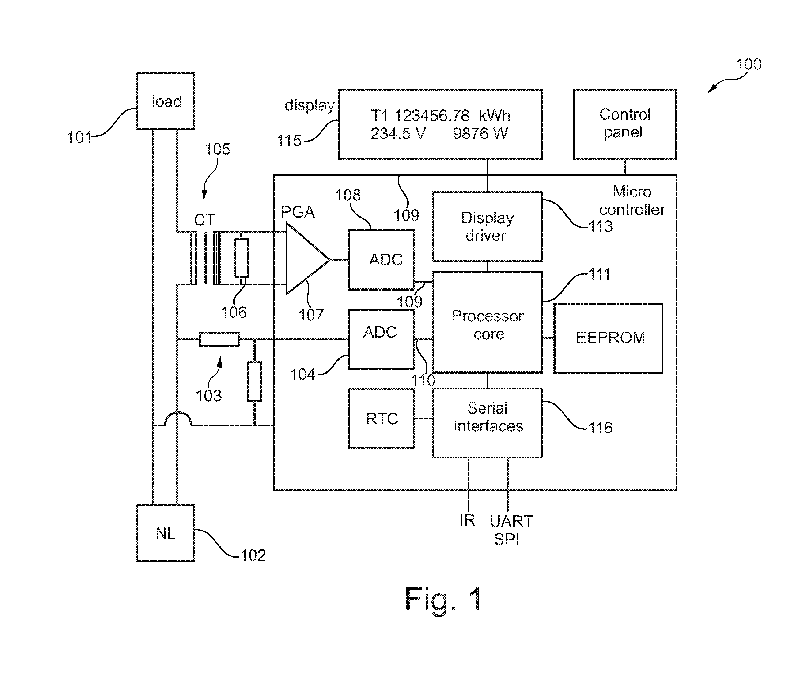

Fig. 1 schematically illustrates a block diagram of an electricity meter 100 according to an embodiment. The electricity meter 100 is a single phase electricity meter, which is adapted to measure voltage and current applied to or running through a load 101. An electric power source 102 is connected to the load 101 causing a current to run through the load 101, whereupon the voltage provided by the power source 102 is applied. The voltage is measured using a resistor voltage divider 103 comprising two resistors, which adapts the voltage to be supplied to the analogue-to-digital-converter (ADC) 104. The ADC 104 samples the divided voltage, which is proportional to the voltage applied to the load 101, and digitizes the sampled values. Thereby, the sampling is performed at a rate between 100 Hz and 100 kHz, in particular at about 4 kHz. In contrast, the electric power supply 102 provides an alternating current and an alternating voltage at a frequency of for example 50 Hz or 60 Hz.

Further, the electric current running through the load 101, runs through a primary coil of the current transformer 105, whereupon an associated electric current is induced in a secondary coil of the coil transformer 105. A voltage being proportional to the current running through the load 101, drops across the shunt resistor 106 to provide input signals to an operational amplifier 107. The output terminal of the operation amplifier 107 is connected to the analogue-to-digital-converter 108, which samples and digitizes the output signal of the operational amplifier 107. In particular, a sampling rate of the ADCs 104 and 108 may be substantially the same.

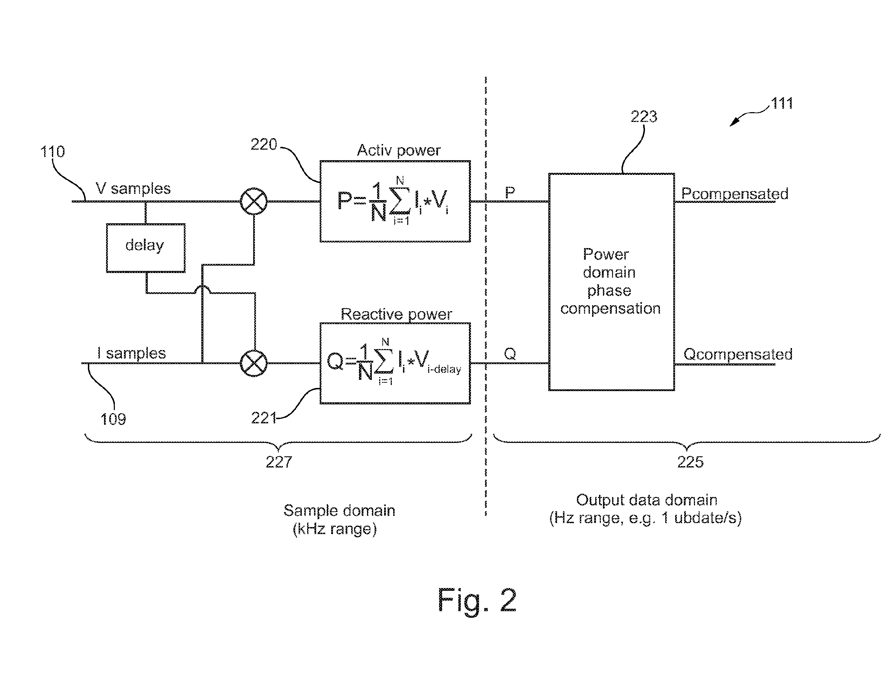

The sampled electric current values are provided via a line 109 to the processor core 111 and the sampled and digitized voltage values are provided via a line 110 to the processor core 111, as also illustrated in Figure 2. Using the sampled and digitized current values and voltage values, which are associated to each other as they are simultaneously sampled and digitized, the processor core 111 derives the active power P (step 220 in Figure 2) by averaging of multiplied current samples and voltage samples according to the following equation:

$$P = \frac{1}{N} \sum_{i=1}^{N} I_i * V_i$$

Further, the processor core 111 derives the reactive power Q (step 221 in Figure 2) by calculating the average of current samples multiplied with 90° shifted voltage samples according to the equation

$$Q = \frac{1}{N} \sum_{i=1}^{N} I_i * V_{i-offset}$$

From the quantity P and Q the apparent power S may be obtained from the equation $S^2 = P^2+Q^2$. As an unknown phase error $\Delta\varphi$ is introduced by the current transformer 105 and the ADCs 104, 108, the active power P and the reactive power Q calculated above, may not represent the actual active power and the actual reactive power. Thus, the processor core 111 performs a calibration (step 223 in Figure 2) to obtain the calibrated values of the active power, i.e. $P_{cal}$ and the calibrated value of the reactive power, i.e. $Q_{cal}$ by correcting the apparent phase shift between voltage and current ($\varphi'$) by the phase error $\Delta\varphi$ as described below.

Fig. 2 schematically illustrates a processor core 111 and a method for determining a quantity according to an embodiment, which may be used in the electricity meter 100 illustrated in Fig. 1. The active power P is calculated using the voltage sample values provided at line 110 and using the current sampled values provided at line 109 and the reactive power Q is calculated using the phase-shifted sampled voltage values and the sampled current values, as illustrated in calculation blocks 220 and 221. The resulting values P and Q are provided to a power domain phase compensation calculation block 223.

For the calibrated powers, first calculate the phase angle φ' of the apparent power vector S with the x-axis:

$$\varphi' = a\tan\left(\frac{Q}{P}\right) \quad or \quad \varphi' = a\cos\left(\frac{P}{|S|}\right) \quad or \quad \varphi' = a\sin\left(\frac{Q}{|S|}\right)$$

Using the predetermined phase error $\Delta\varphi$, the calculation block 223 derives the quantities $P_{cal}$ and $Q_{cal}$ according to the following equations.

$$P_{cal} = |S| \cdot \cos\left(\varphi' - a\tan\left(\frac{Q_{resistiveload}}{P_{resistiveload}}\right)\right)$$

or approximately $$P_{cal} = |S| \cdot \cos\left(\varphi' - \left(\frac{Q_{resistiveload}}{P_{resistiveload}}\right)\right)$$

$$Q_{cal} = |S| \cdot \sin\left(\varphi' - a\tan\left(\frac{Q_{resistiveload}}{P_{resistiveload}}\right)\right)$$

or approximately $$Q_{cal} = |S| \cdot \sin\left(\varphi' - \left(\frac{Q_{resistiveload}}{P_{resistiveload}}\right)\right)$$

Also the equation

$$Q_{cal} = \sqrt{|S|^2 - P_{cal}^2}$$

can be used when this calculation is more efficient. The approximations can be used When $Q_{resistiveload} \ll P_{resistiveload}$.

Herein $Q_{resistiveload}$ represents the uncalibrated reactive power, when the load 101 is purely resistive, and $P_{resistiveload}$ represents the uncalibrated active power, when the load 101 is purely resistive. These values are measured in a calibration measurement in advance only once and need not to be measured repeatedly.

Thereby, the compensation or correction is performed entirely within the output data domain 225, while sampling of the current and the voltage is performed within the sample domain 227. In particular, sampling is performed at a rate in the order of kHz, while output of the compensated or corrected derived quantities $P_{cal}$ and $Q_{cal}$ is performed in the order of one value per second (1 Hz).

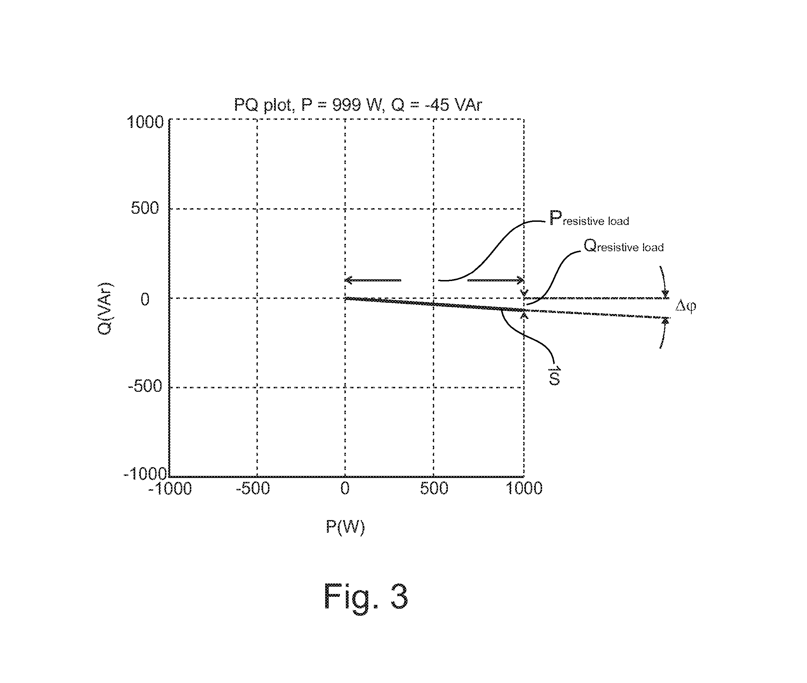

Fig. 3 schematically illustrates a graph during a calibration or determination of the phase error $\Delta\varphi$ according to an embodiment, which may proceed the actual method for determining the electric quantity illustrated in Figure 2. In the illustrated method for determining the phase error, a resistive load consuming 1000 W is used as a load 101 in the electricity meter 100 illustrated in Fig. 1. According to another embodiment, not a resistive load but any other load, such as a capacitive load, an inductive load or a load having capacitive, inductive and/or resistive load, may be used for determining the phase error.

Fig. 3 illustrates on its abscissa the active power P and on its ordinate the reactive power Q. The measurement of the resistive load produces a vector S having a component in the P-direction and having a small component in the Q-direction. The angle between the component in the P-direction and the vector S is denoted as the phase error $\Delta\varphi$. The resistive load, as illustrated in Fig. 3, has a power factor of 1 (cos($\varphi$)=1) and consumes only active power with reactive power Q = 0 VAr (voltage ampere reactive). Thus, it is expected that the Q-component is zero. What is actually measured, using the not calibrated electricity meter 100 illustrated in Fig. 1, is the graph illustrated in Fig. 3 having a component Q being not equal to zero. This component is due to the phase error $\Delta\varphi$, which may be determined according to the following equations:

$$\Delta\varphi = a\tan\left(\frac{Q_{resistiveload}}{P_{resistiveload}}\right)$$

or

$$\Delta\varphi = a\cos\left(\frac{P_{resistiveload}}{|S|_{resistiveload}}\right)$$

or

$$\Delta\varphi = a\sin\left(\frac{Q_{resistiveload}}{|S|_{resistiveload}}\right)$$

Having determined the afore unknown phase error $\Delta\varphi$, the processor core 111 illustrated in Fig. 2 may perform the compensation or correction within the calculation block 223 to output the compensated or calibrated active power $P_{cal}$ and reactive power $Q_{cal}$, respectively. The unambiguous value for $\varphi$ (between 0 and $2\pi$) can be determined by considering the sign of P and Q. The calibrated values $P_{cal}$ and $Q_{cal}$ can be calculated from |S|, $\varphi$ and the power measurement for the reference resistive load $P_{resistiveload}$ and $Q_{resistiveload}$.

The actual phase shift $\varphi$ may then be calculated using

$$\varphi = \varphi' - \Delta\varphi .$$

The calibrated apparent power $|S_{cal}|$ remains equal to the un-calibrated apparent power |S|.

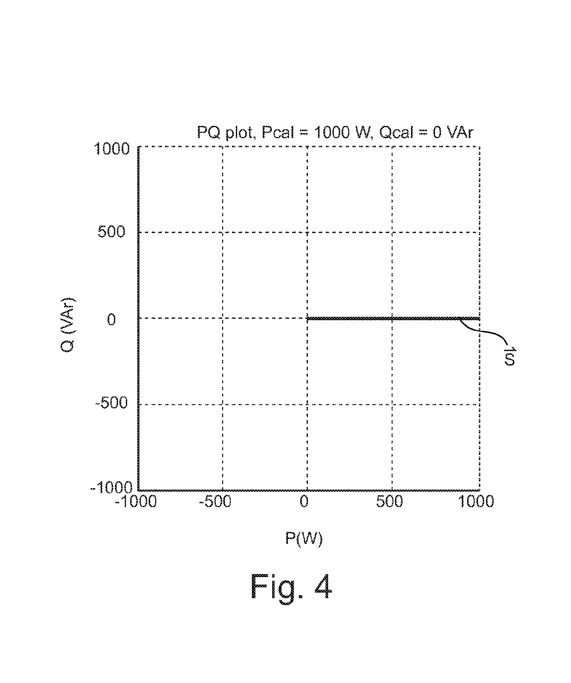

After calibration, the electricity meter 100 illustrated in Fig. 1 measuring the resistive load results in the graph illustrated in Fig. 4. As can be seen, the reactive load Q is zero as expected and the load is measured to be purely resistive as expected. After this calibration or correction step the processor core 111 is prepared for measuring other voltages and currents, in particular alternating voltages and currents.

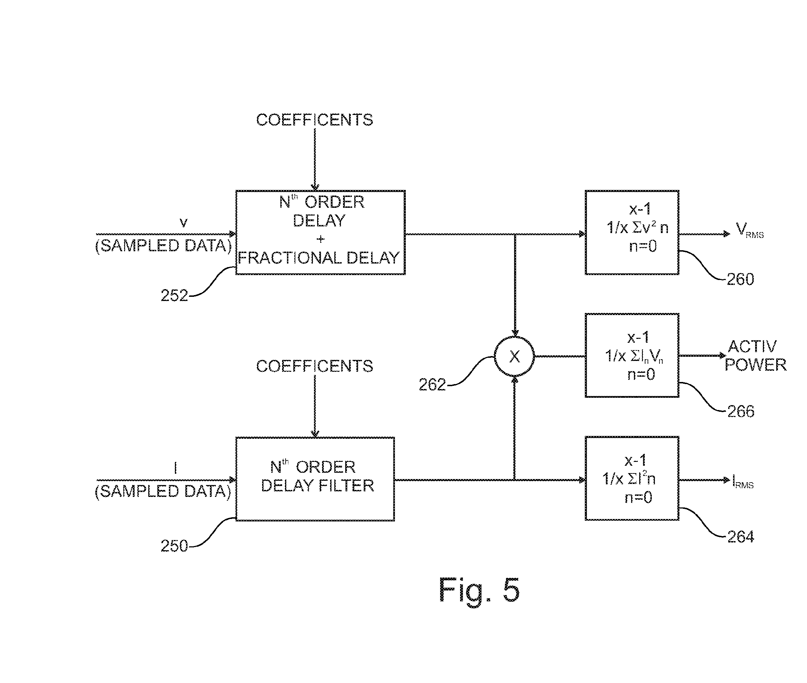

Fig. 5 schematically shows a conventional phase compensation method, in which each of the sampled data for the voltage V and the current I are delayed using delay filters 252 and 250. Only after correction of these sampled data by the delay filters, the active power is computed in a calculation block 266. Thereby, many correction steps and computations are needed to compensate for a phase error between voltage and current.

Referring again to Figure 1, the compensated or calibrated derived quantity $P_{cal}$ and $Q_{cal}$ are then supplied to the display driver 113 illustrated in Figure 1 which supplies display data to the display 115. On the display 115 the calibrated or corrected active power $P_{cal}$ and reactive power $Q_{cal}$ may be displayed. The compensated or calibrated derived quantity $P_{cal}$ and $Q_{cal}$ can also be supplied to the serial interfaces 116 illustrated in Figure 1 which supplies data to other devices for display, transmission or further processing.

REFERENCE SIGNS

| | |
|---|---|
| 100 | electricity meter |
| 101 | load |
| 102 | electric power supply |
| 103 | resistor voltage divider |
| 104, 108 | ADC |
| 105 | current transformer |
| 106 | shunt resistance |
| 107 | operational amplifier |
| 109, 110 | data line |
| 111 | processor core |
| 113 | display driver |
| 115 | display |
| 116 | serial interfaces |
| 220, 221, 223 | calculation blocks |
| 225 | output data domain |
| 227 | sample domain |

**Claims**

1. A method for determining a quantity, the method comprising:

    acquiring an electric current value ($I_i$) and an electric voltage value ($V_i$) associated with the electric current value;
    further acquiring at least one further electric current value and at least one further electric voltage value associated with the at least one further electric current value;
    deriving the quantity (P, Q) based on the current value, on the associated voltage value, on the at least one further current value, and on the associated at least one further voltage value;
    correcting the derived quantity based on a predetermined phase error ($\Delta\varphi$) between the current value and the associated voltage value and between the at least one further current value and the at least one further associated voltage value.

2. The method according to claim 1, wherein the deriving the quantity, in particular at a rate between 0.1 Hz and 60 Hz, comprises multiplying
    at least one of the current value and the at least one further current value with at least one of the voltage value and the at least one further voltage value.

3. The method according to claim 1, wherein the multiplying comprises multiplying

the current value with the voltage value and multiplying
the at least one further current value with the at least one further voltage value.

4. The method according to claim 2, wherein the deriving the quantity further comprises forming a sum of at least two products obtained by the multiplying.

5. The method according to claim 1, wherein the correcting the derived quantity comprises determining an apparent phase shift ($\varphi$') between the current value and associated voltage value and between the at least one further current value and the at least one further associated voltage value.

6. The method according to claim 5, wherein the correcting the derived quantity further comprises correcting the apparent phase shift using the predetermined phase error.

7. The method according to claim 6, wherein the correcting the derived quantity further comprises evaluating a trigonometric function depending on the corrected apparent phase shift.

8. The method according to claim 1, wherein the acquiring and/or the further acquiring comprises sampling, in particular at a rate between 1 kHz and 10 kHz, and/or digitizing the electric current value and/or the associated electric voltage value and/or the at least one further electric current value and/or the at least one further associated electric voltage value.

9. The method according to claim 1, wherein the acquiring the electric current value and/or the further acquiring the at least one further electric current value comprises:

transforming a load current and/or at least one further load current using a transformer or
running a load current and/or at least one further load current through a series resistor and measuring a voltage drop and/or at least one further voltage drop across the series resistor.

10. The method according to claim 1, wherein the acquiring the electric voltage value and/or the further acquiring the at least one further electric voltage value comprises providing a resistor voltage divider and sensing a voltage drop and at least one further voltage drop occurring across at least one resistor of the resistor voltage divider
or
providing a power source voltage to a primary side of a voltage transformer and sensing a voltage and at least one further voltage on a secondary side of the voltage transformer.

11. The method according to claim 1, wherein the quantity is an active power (P) and/or a reactive power (Q) and/or an apparent power and/or a power factor.

12. The method according to claim 1, further comprising determining the predetermined phase error between the current value and associated voltage value and between the between the at least one further current value and the at least one further associated voltage value by
acquiring a reference electric current value and a reference electric voltage value associated with the reference electric current value and
further acquiring at least one further reference electric current value and at least one further reference electric voltage value associated with the at least one further reference electric current value,
wherein a predetermined reference phase shift is present between the reference current value and associated reference voltage value and between the at least one further reference current value and the at least one further associated reference voltage value.

13. An electricity meter (100) for determining a quantity, the electricity meter comprising:

a current terminal for acquiring an electric current value and at least one further electric current value;
a voltage terminal for acquiring an electric voltage value associated with the electric current value and at least one further electric voltage value associated with the at least one further electric current value;
a processing apparatus adapted
for deriving the quantity based on the current value, on the associated voltage value, on the at least one further current value, and on the associated at least one further voltage value; and
for correcting the derived quantity based on a predetermined phase error between the current value and the associated voltage value and between the at least one further current value and the at least one further associated voltage value.

14. A computer-readable medium, in which a computer program of determining a quantity is stored, which computer program, when being executed by a processor, is adapted to carry out or control a method according to claim 1.

15. A program element of determining a quantity, which program element, when being executed by a processor, is adapted to carry out or control a method according to claim 1.

Fig. 1

Fig. 2

EP 2 397 864 A1

Fig. 3

PQ plot, Pcal = 1000 W, Qcal = 0 VAr

Q (VAr)

P(W)

Fig. 4

Fig. 5

Europäisches
Patentamt

European
Patent Office

Office européen
des brevets

## EUROPEAN SEARCH REPORT

Application Number

EP 10 16 6497

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GB 2 319 345 A (GEC METERS LTD [GB]; ABB METERING SYST LTD [GB]) 20 May 1998 (1998-05-20) * abstract; figures * * page 10, paragraph 2 - page 11, paragraph 1 * | 1-15 | INV. G01R35/04 G01R21/133 |
| X | US 6 185 508 B1 (VAN DOORN PETER M [CA] ET AL) 6 February 2001 (2001-02-06) * abstract; figures 1,3,4,8 * | 1,13-15 | |
| X | US 2010/145642 A1 (SLOTA FREDERICK BLAIR [US] ET AL) 10 June 2010 (2010-06-10) * abstract; figures * | 1,13-15 | |
| | | | TECHNICAL FIELDS SEARCHED (IPC) |
| | | | G01R |

The present search report has been drawn up for all claims

| Place of search | Date of completion of the search | Examiner |
|---|---|---|
| Berlin | 23 November 2010 | Fritz, Stephan C. |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**ANNEX TO THE EUROPEAN SEARCH REPORT
ON EUROPEAN PATENT APPLICATION NO.**

EP 10 16 6497

This annex lists the patent family members relating to the patent documents cited in the above-mentioned European search report.
The members are as contained in the European Patent Office EDP file on
The European Patent Office is in no way liable for these particulars which are merely given for the purpose of information.

23-11-2010

| Patent document cited in search report | | Publication date | Patent family member(s) | | Publication date |
|---|---|---|---|---|---|
| GB 2319345 | A | 20-05-1998 | NONE | | |
| US 6185508 | B1 | 06-02-2001 | CA | 2148075 A1 | 01-07-1996 |
| | | | US | 5736847 A | 07-04-1998 |
| US 2010145642 | A1 | 10-06-2010 | US | 2006085144 A1 | 20-04-2006 |
| | | | US | 2008125986 A1 | 29-05-2008 |

EPO FORM P0459

For more details about this annex : see Official Journal of the European Patent Office, No. 12/82

**EP 2 397 864 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 03021279 A1